(19) Europäisches Patentamt
European Patent Office
Office européen des brevets

(11) Veröffentlichungsnummer: **0 356 787**
**A2**

(12) **EUROPÄISCHE PATENTANMELDUNG**

(21) Anmeldenummer: 89114879.3

(51) Int. Cl.5: **G01R 33/04**

(22) Anmeldetag: 11.08.89

(30) Priorität: 30.08.88 DE 3829269

(43) Veröffentlichungstag der Anmeldung:
07.03.90 Patentblatt 90/10

(84) Benannte Vertragsstaaten:
AT BE CH DE FR GB IT LI NL

(71) Anmelder: LEYBOLD AKTIENGESELLSCHAFT
Wilhelm-Rohn-Strasse 25
D-6450 Hanau 1(DE)

(72) Erfinder: Klein, Hans-Hermann, Dr.
Benrathweg 22a
D-6360 Friedberg(DE)
Erfinder: Strasser, Wilhelm
Reiser 9
D-5060 Bergisch-Gladbach 1(DE)
Erfinder: Timm, Uwe, Dr.
Oberlindau 81
D-6000 Frankfurt(DE)

(74) Vertreter: Leineweber, Jürgen, Dipl.-Phys.
Nagelschmiedshütte 8
D-5000 Köln 40(DE)

(54) Indikator zum Nachweis des Überschreitens einer bestimmten Feldstärke eines Magnetfeldes.

(57) Die Erfindung bezieht sich auf einen Indikator zum Nachweis des Überschreitens einer bestimmten Feldstärke eines Magnetfeldes; dieser umfaßt einen Sensormagneten (1, 2) mit einer bestimmten Koerzitivfeldstärke $H_c$, welcher die Eigenschaft hat, seine Magnetisierungsrichtung umzukehren, wenn ein die Feldstärke $H_c$ überschreitendes Magnetfeld in entgegengesetzter Richtung wirkt, und Mittel zur Erkennung der Umkehr der Magnetisierungsrichtung.

FIG.9a

FIG.9b

EP 0 356 787 A2

# Indikator zum Nachweis des Überschreitens einer bestimmten Feldstärke eines Magnetfeldes

Viele Produkte, z. B. mit einem Magneten ausgerüstete Bauteile oder Geräte, Maschinen (z. B. Antriebsmotoren), elektronische Speicher, Computer oder dergleichen, sind empfindlich gegen äußere Magnetfelder. Gelangen sie in ein Magnetfeld, dessen Stärke einen kritischen Wert übersteigt, dann können Veränderungen von Eigenschaften auftreten, die die Funktion des Gerätes oder der Maschine mehr oder weniger - bis zum Ausfall - beeinträchtigen.

Die Hersteller von gegen Magnetfelder empfindlichen Produkten geben zwar maximal zulässige Feldstärken von Umgebungsmagnetfeldern an; bisher war es jedoch nicht möglich, nachzuweisen, ob die Ursache für eine eingetretene Fehlfunktion ein zu starkes äußeres Magnetfeld war oder nicht.

Der vorliegenden Erfindung liegt die Aufgabe zugrunde, einen Indikator zu schaffen, mit dem der Nachweis des Überschreitens einer bestimmten Feldstärke eines umgebenden Magnetfeldes möglich ist.

Erfindungsgemäß ist dieser Indikator gekennzeichnet durch einen Sensormagneten mit einer bestimmten Koerzitivfeldstärke $H_c$, welcher die Eigenschaft hat, seine Magnetisierungsrichtung umzukehren, wenn ein Magnetfeld mit einer die Feldstärke $H_c$ überschreitenden Feldstärke $H_a$ in entgegengesetzter Richtung wirkt, und durch Mittel zur Erkennung der Umkehr der Magnetisierungsrichtung.

Magnete, die ihre Polarität verändern, wenn ein ihre Koerzitivfeldstärke übersteigendes Magnetfeld in entgegengesetzter Richtung wirkt, sind an sich bekannt. Im Laufe ihres Fertigungsverfahrens (speziell beim Glühprozeß) läßt sich ihre Koerzitivfeldstärke in einem großen Bereich einstellen. Unter den Namen Magnetoflex" und "Vacoflux" sind Magneten mit der beschriebenen Eigenschaft auf dem Markt erhältlich.

Verwendet man einen oder mehrere Dauermagneten mit dieser Eigenschaft als Sensormagnet bzw. als Sensormagneten im Sinne der Erfindung, dann ist es möglich, anzuzeigen, ob zeitweise ein Magnetfeld mit einer die Koerzitivfeldstärke $H_c$ des Sensormagneten übersteigenden Feldstärke $H_a$ gewirkt hat. Rüstet man ein gegen Magnetfelder empfindliches Produkt mit einem Indikator der erfindungsgemäßen Art aus, dann läßt sich nach der Feststellung einer Fehlfunktion nachprüfen, ob der Gegenstand zeitweise einem Magnetfeld mit zu hoher Feldstärke ausgesetzt war oder nicht. Das Ergebnis dieser Prüfung erleichtert zum einen die Fehlersuche und kann zum anderen zur Klärung von Haftungsfragen beitragen.

Es besteht die Möglichkeit, zur Feststellung bzw. Anzeige der Umkehr der Magnetisierungsrichtung elektrische Mittel einzusetzen, z. B. eine Hall-Sonde umgeben.

Zur Registrierung der Umkehr der Magnetisierungsrichtung mit elektrischen Mitteln ist es weiterhin zweckmäßig, wenn der oder die Sensormagneten in Form von Impulsdrähten vorliegen. Impulsdrähte sind Verbund-Magnete, die aus einer weich- ($H_{c1} \leq 25$ A/cm) und einer hartmagnetischen ($H_{c2} \geq 250$ A/cm) Komponente bestehen und von einer Sensorspule umgeben sind. In der Sensorspule werden in einem magnetischen Wechselfeld, dessen Amplitude größer als $H_{c1}$ und kleiner als $H_{c2}$ ist, Spannungsimpulse induziert, deren Polarität von der Magnetisierungrichtung der hartmagnetischen Komponente abhängt. Die hartmagnetische Komponente dient im vorliegenden Fall als Sensormagnet. Wird nämlich ein solcher Impulsdraht in ein statisches Magnetfeld mit $H_a > H_{c2}$ gebracht, kann sich die Magnetisierungsrichtung der hartmagnetischen Komponente ändern, und in einem schwachen magnetischen Wechselfeld werden in der Sensorspule z. B. positive Spannungsimpulse induziert statt vorher negative. Bei einem Impulsdraht, der zeitweise einem gegen Magnetfelder empfindlichen Produkt beigefügt war, läßt sich also nachträglich feststellen, ob seine hartmagnetische Komponente die Magnetisierungsrichtung geändert hat oder nicht.

Besonders zweckmäßig ist es, die Sensormagneten paarweise - mit ursprünglich entgegengesetzt gerichteter Magnetisierung - einzusetzen. Bewirkt ein äußeres Magnetfeld die Umkehr der Magnetisierungsrichtung eines der beiden Sensormagneten, dann geht der antiparallele Magnetisierungszustand in einen parallelen Magnetisierungszustand über. Mit einer Hall-Sonde oder - falls die Sensormagneten in Form von Impulsdrähten vorliegen - mit Hilfe eines magnetischen Wechselfeldes (in einer Feldspule), lassen sich der parallele oder antiparallele Magnetisierungszustand in einfacher Weise feststellen. Ein besonderer Vorteil liegt darin, daß der parallele Magnetisierungszustand durch ein äußeres Magnetfeld nicht mehr rückgängig gemacht werden kann. Gerät der Indikator nochmals in ein Magnetfeld mit zu hoher Feldstärke, dessen Richtung zufällig dem ersten Störmagnetfeld exakt entgegengerichtet ist, dann werden beide Sensormagneten ihre Polarität umkehren. Der parallele Magnetisierungszustand läßt sich durch äußere Magnetfelder nicht mehr verändern.

Nachteilig an einer elektrischen Anzeige (Hall-Sonde, Feststellung der Polarität elektrischer Impulse) ist, daß zusätzliche Geräte zum Nachweis der Ummagnetisierung der Sensormagnete benötigt werden. Wünschenswert sind deshalb Anordnungen, bei denen infolge der Einwirkung eines äußeren Magnetfeldes optisch erkennbare Veränderungen eintreten, die vorzugsweise irreversibel sind. Dieses Ziel kann dadurch erreicht werden, daß bei einer Anordnung mit zwei parallel angeordneten Sensormagneten mit ursprünglich entgegengesetzt gerichteter Polarität mindestens einer der beiden Sensormagneten senkrecht zu seiner Längsrichtung verschiebbar angeordnet ist. Solange die entgegengesetzt gerichtete Polarität besteht, ziehen die Sensormagnete einander an, liegen also unmittelbar nebeneinander. Gelangt das System in ein Magnetfeld mit einer die Koerzitivfeldstärke der Sensormagneten übersteigenden Feldstärke, dann verändert einer der Sensormagneten seine Polarität. Aufgrund dieses parallelen Magnetisierungszustandes stoßen die Sensormagneten einander ab. Sie werden also eine voneinander beabstandete Lage einnehmen, so daß optisch erkennbar ist, ob zeitweise ein Magnetfeld mit zu hoher Feldstärke bestanden hat. Auch bei dieser Lösung kann der parallele Magnetisierungszustand durch ein äußeres Magnetfeld nicht mehr in einen antiparallelen Magnetisierungszustand rückgängig gemacht werden.

Entscheidend für die Polaritätsumkehr ist die Komponente des magnetischen Feldes $H_a$, die entgegen der Koerzitivfeldstärke $H_c$ des Sensormagneten wirkt. Da nicht vorhersehbar ist, mit welcher räumlichen Anordnung ein Gegenstand in ein Magnetfeld gerät, ist es zweckmäßig, mehrere Sensormagneten mit räumlich unterschiedlichen Magnetisierungsrichtungen vorzusehen. Je größer die Anzahl der mit unterschiedlichen Magnetisierungsrichtungen angeordneten Sensormagneten ist, desto größer ist die Genauigkeit, mit der feststellbar ist, ob ein Magnetfeld beliebiger Richtung einen festen Wert überschritten hat.

Die Anzahl der benötigten Sensormagneten wird jedoch groß, wenn eine Genauigkeit von besser als 5% verlangt wird. Eine besonders vorteilhafte Maßnahme besteht deshalb darin, den oder die Sensormagneten mit einem Kompaß- oder Richtmagneten zu versehen und das aus Richtmagnet und Sensormagnet(en) bestehende System frei drehbar aufzuhängen. Dabei muß der Richtmagnet ein größeres magnetisches Dipolmoment besitzen als der oder die Sensormagneten, damit er in der Lage ist, den oder die Sensormagneten in einem äußeren Magnetfeld mit einer definierten Position - vorzugsweise parallel zu den Feldlinien - auszurichten. Der Richtmagnet selbst steht immer parallel zu dem äußeren Magnetfeld, so daß seine Magnetisierungsrichtung in einem äußeren Magnetfeld sich nicht umkehren kann.

Weitere Vorteile und Einzelheiten der Erfindung sollen anhand der Figuren 1 bis 11 erläutert werden. Es zeigen

Figuren 1 bis 3 schematisch unterschiedliche Sensormagnetsysteme,

Figur 4 einen Sensormagneten mit einer Hall-Sonde,

Figur 5 Impulsdrähte

Figur 6 eine Lösung, die sowohl eine optische als auch eine elektrische Anzeige der Umkehr der Magnetisierungsrichtung ermöglicht,

Figur 7 eine Lösung mit mehreren, achsparallel zueinander angeordneten Sensormagneten, Magnetisierungsrichtung z. T. verschieden

Figur 8 eine Lösung mit mehreren Sensormagnetpaaren unterschiedlicher Richtung,

Figuren 9 bis 11 Lösungen mit Richtmagneten.

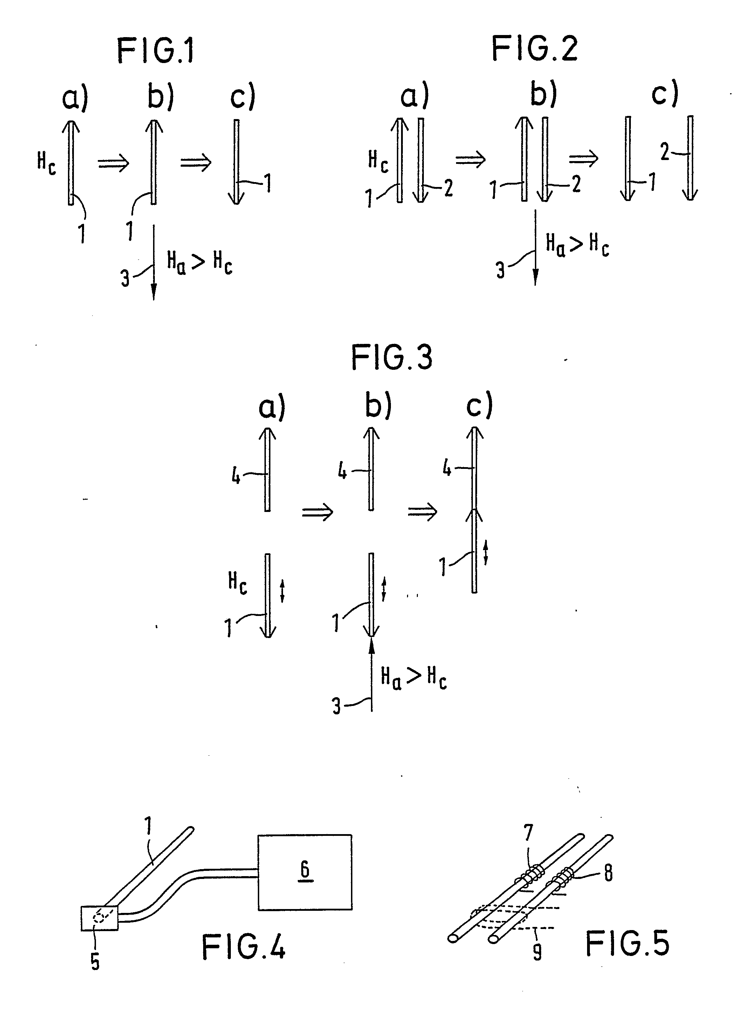

Figur 1 zeigt schematisch einen Sensormagneten 1 mit einer Koerzitivfeldstärke $H_c$, der in der Lage ist, seine Magnetisierungsrichtung umzukehren. Wirkt ein äußeres Magnetfeld, dessen Feldstärke $H_a$ größer ist als die Koerzitivfeldstärke $H_c$ des Sensormagneten in entgegengesetzter Richtung (Figur 1, b) dann kehrt der Sensormagnet seine Magnetisierung um, wie es in Figur 1, c dargestellt ist.

Figur 2 zeigt zwei parallel zueinander angeordnete Sensormagneten 1, 2, die ursprünglich (Figur 2, a) antiparallele Magnetisierungsrichtungen haben. Wirkt ein äußeres Magnetfeld mit einer Feldstärke $H_a$, die größer ist als die Koerzitivfeldstärke der Sensormagneten 1, 2, entsprechend dem Pfeil 3, dann kehrt der Sensormagnet 1 seine Magnetisierung um. Der antiparallele Magnetisierungszustand geht in einen parallelen Magnetisierungszustand über (Figur 2, c). Die beiden Sensormagneten 1, 2, die sich ursprünglich anzogen, stoßen nun einander ab. Ist einer der beiden Sensormagneten 1 oder 2 senkrecht zu seiner Längsachse verschiebbar, dann nehmen sie die in Figur 2, c dargestellte, beabstandete Position an.

Beim Ausführungsbeispiel nach Figur 3 sind zwei Magneten 1, 4 vorgesehen, die axial hintereinander angeordnet sind. Der Magnet 4 kann ein Sensormagnet oder ein Richtmagnet sein. Der Sensormagnet 1 ist längs seiner Achse verschiebbar. Im Ausgangszustand (Figur 3, a) sind die Magneten 1, 4 antiparallel magnetisiert. Sie stoßen einander ab. Wirkt zeitweise ein äußeres Magnetfeld entsprechend dem Pfeil 3 mit $H_a > H_c$ (Figur 3, b), dann kehrt der Magnet 1 seine Magnetisierungsrichtung um. Die Magneten 1 und 4 ziehen dann einander an (Figur 3, c), so daß sich der Magnet 1 in Richtung Magnet 4 bewegt.

Figur 4 zeigt einen mit einer Hall-Sonde 5 versehenen Sensormagneten 1. Kehrt der Sensormagnet 1 seine Magnetisierung um, dann entsteht in der Hall-Sonde eine Spannung, die der Ausgangsspannung entgegengesetzt ist.

Eine andere Möglichkeit, die Polaritätsumkehr von Sensormagneten 1, 2 festzustellen, besteht darin, Impulsdrähte zu verwenden, die jeweils mit einer Pickup-Spule 7, 8 ausgerüstet sind oder sich zusammen in einer Pickup-Spule (gestrichelt dargestellte Spule 9) befinden. Die Spulen 7, 8 liefern in einem schwachen magnetischen Wechselfeld Spannungsimpulse, aus deren Polarität man auf die Magnetisierungsrichtung der hartmagnetischen Komponenten der Impulsdrähte schließen kann.

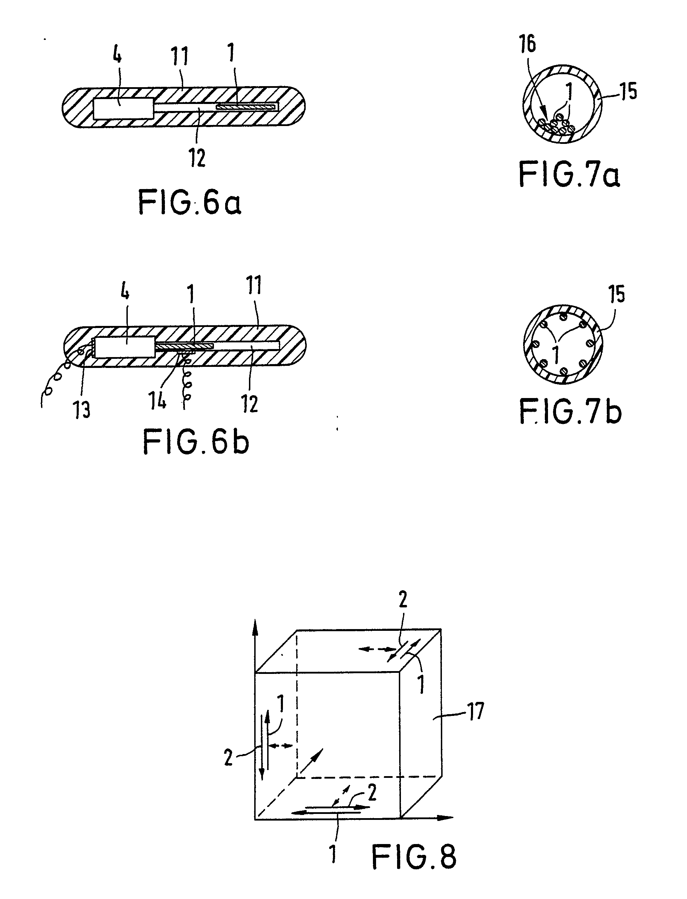

Figur 6 zeigt ein Ausführungsbeispiel mit einem Sensormagneten (1) und einem Richtmagneten 4, die entsprechend Figur 3 längs zueinander angeordnet sind. Der Richtmagnet 4 ist fest in einem durchsichtigen Kunststoffkörper 11 angeordnet. Der Sensormagnet 1 befindet sich in einer Bohrung 12, die länger ist als der Sensormagnet 1. In seinem Ursprungszustand weist der Sensormagnet 1 eine Magnetisierungsrichtung auf, die bewirkt, daß sich der Sensormagnet 1 und der Richtmagnet 4 abstoßen. Gerät dieses System in ein Magnetfeld mit einer der Magnetisierungsrichtung des Sensormagneten entgegengerichteten, größeren Feldstärke, dann vertauscht der Sensormagnet 1 seine Pole. Die beiden Magneten 1 und 4 ziehen nun einander an, so daß sich der Sensormagnet 1 in die in Figur 6, b dargestellte Lage bewegt. Dadurch wird optisch erkennbar, daß ein äußeres Magnetfeld mit einer eine bestimmte Größe überschreitenden Feldstärke gewirkt hat. Besonders vorteilhaft ist es, wenn das in Figur 6 dargestellte, aus Richtmagnet 4 und Sensormagnet 1 bestehende System frei drehbar aufgehängt ist. Aufgrund der Wirkung des Richtmagneten 4 wird sich ein solches System parallel zu den Feldlinien des äußeren Magnetfeldes einstellen. Dadurch ist sichergestellt, daß auf den Sensormagneten 1 stets die maximale Feldstärke des äußeren Magnetfeldes einwirkt. Auch bei einem Magnetsystem nach Figur 2 kann einer der beiden achs-parallel zueinander angeordneten Magneten ein Richtmagnet sein.

In Figur 6, b sind elektrische Kontakte 13 und 14 eingezeichnet. Kontakt 13 liegt ständig dem Richtmagneten 4 an. Kontakt 14 liegt dem Sensormagneten 1 nur dann an, wenn er den Richtmagneten 4 berührt. Sensormagnet 1 und Richtmagnet 4 bilden dadurch einen Schalter, der bei einer Lage des Sensormagneten 1 nach Figur 6, a offen und bei einer Lage des Sensormagneten 1 nach Figur 6, b geschlossen ist.

Figur 7 zeigt einen Schnitt durch ein durchsichtiges Röhrchen 15, in dem sich mehrere (acht) Sensormagneten 1 befinden. Diese sind im Ursprungszustand antiparallel - vorzugsweise paarweise antiparallel - magnetisiert. Sie liegen dann in Form eines Bündels 16 vor, das infolge der Schwerkraft seine unterste Stellung im Röhrchen 15 einnimmt. Gelangt dieses Röhrchen 15 in ein äußeres Magnetfeld mit ausreichend hoher Feldstärke, dann geht der antiparallele Magnetisierungszustand in einen parallelen Magnetisierungszustand über. Alle Sensormagneten 1 stoßen dann einander ab. Sie nehmen dann eine gleichmäßig über dem inneren Umfang des Röhrchens 15 verteilte Lage ein (vgl. Figur 7, b).

Sind die anhand der vorstehenden Figuren beschriebenen Magnetsysteme nicht frei drehbar gelagert, dann können sie nur eine Dimension des zu prüfenden Magnetfeldes erfassen. Andere Richtungen müssen durch weitere Magnetsysteme abgedeckt werden. Figur 8 zeigt drei Magnetpaare, jeweils mit Sensormagneten 1, 2, die jeweils senkrecht zueinander angeordnet sind. Sie nehmen eine jeweils zu den Kanten eines Würfels 17 parallele Lage ein. Bei einer derartigen Lösung eines erfindungsgemäßen Indikators liegt der ungünstigste Fall vor, wenn das äußere Magnetfeld in Richtung einer Raumdiagonalen liegt. Zur genaueren Erfassung äußerer Magnetfelder könnten weitere Sensormagnetpaare in Richtung der Raumdiagonalen angeordnet sein.

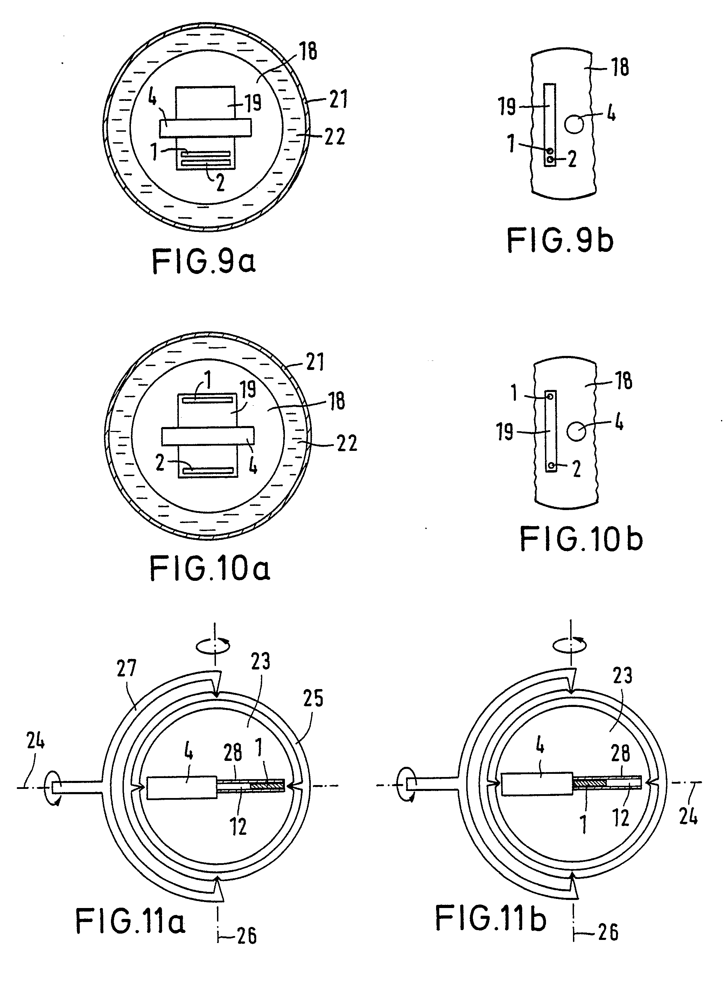

Auf die Verwendung einer Mehrzahl von Sensormagneten kann verzichtet werden, wenn frei drehbare Systeme mit einem Richtmagneten verwendet werden, wie sie in den Figuren 9 bis 11 dargestellt sind. Die Figuren 9 und 10 zeigen ein aus einem Richtmagneten 4 und zwei Sensormagneten 1, 2 bestehendes Magnetsystem, das innerhalb einer durchsichtigen Kugel 18, vorzugsweise aus Kunststoff, untergebracht ist. Die beiden Sensormagneten 1, 2 befinden sich in einer quaderförmigen Kammer 19. Der Richtmagnet 4 ist parallel dazu und neben der Kammer 19 angeordnet (vgl. Figur 9, b und Figur 10, b).

Die Kugel 18 befindet sich in einem ebenfalls kugelförmigen Behälter 21, der mit einer Flüssigkeit 22 gefüllt ist. Die Dichten der Kugel 18 und der Flüssigkeit 22 sind so gewählt, daß in etwa ein Schwebezustand, d. h. eine freie Drehbarkeit der Kugel 18 in jede Richtung möglich ist. Infolge des Richtmagneten 4 kann sich deshalb die Kugel 18 derart in einem äußeren Magnetfeld ausrichten, daß die Sensormagneten 1, 2 parallel zu den Feldlinien liegen. Ist das äußere Magnetfeld ausreichend groß, dann geht der ursprünglich antiparallele Magnetisierungszustand (Figur 9) mit einander anliegenden Sensormagneten 1, 2 in einen parallelen Magnetisierungszustand über. Die Sensormagneten 1, 2 stoßen dann einander ab (vgl. Figur 10) und nehmen eine voneinander beabstandete Position ein. Dadurch wird optisch erkennbar, daß ein eine bestimmte Feldstärke überschreitendes Magnetfeld eingewirkt hat.

Figur 11 zeigt ein Magnetsystem mit einem Richtmagneten 4 und einem Sensormagneten 1, wie es in Figur 6 dargestellt ist. Es befindet sich in einem durchsichtigen, vorzugsweise aus Kunststoff bestehenden kugelförmigen Körper 23, wobei die Kugelform nicht zwingend ist. Der Körper 23 ist um die Achse 24 drehbar im Ring 25 aufgehängt. Der Ring 25 ist seinerseits um eine dazu senkrechte Achse 26 drehbar im Bügel 27 aufgehängt. Aufgrund einer derartigen cardanischen Aufhängung kann sich das aus Richtmagnet 4 und Sensormagnet 1 bestehende System frei im Raum einstellen und der Richtung der Feldlinien eines äußeren Magnetfeldes anpassen. Um eine möglichst reibungsfreie Verschiebung des Sensormagneten 1 im Raum 12 zu ermöglichen, ist ein Glasröhrchen 28 vorgesehen, das in den Körper 23 eingelassen ist.

## Ansprüche

1. Indikator zum Nachweis des Überschreitens einer bestimmten Feldstärke eines Magnetfeldes, gekennzeichnet durch die Verwendung mindestens eines Sensormagneten (1, 2) mit einer bestimmten Koerzitivfeldstärke $H_c$, welcher die Eigenschaft hat, seine Magnetisierungsrichtung umzukehren, wenn ein die Feldstärke $H_c$ überschreitendes Magnetfeld in entgegengesetzter Richtung wirkt, und durch Mittel zur Erkennung der Umkehr der Magnetisierungsrichtung.

2. Indikator nach Anspruch 1, dadurch gekennzeichnet, daß er mit zwei parallel angeordneten Sensormagneten (1, 2) mit im ursprünglichen Zustand entgegengesetzt gerichteter Magnetisierung ausgerüstet ist.

3. Indikator nach Anspruch 2, dadurch gekennzeichnet, daß drei Sensormagnetpaare vorgesehen sind, deren Längsrichtungen sich jeweils senkrecht zueinander erstrecken.

4. Indikator nach Anspruch 1, dadurch gekennzeichnet, daß zwei Sensormagnete (1, 4) vorgesehen sind, die in Längsrichtung hintereinander angeordnet sind.

5. Indikator nach Anspruch 1, dadurch gekennzeichnet, daß eine Mehrzahl (z. B. 6 bis 10) Sensormagneten (1) mit im ursprünglichen Zustand paarweise antiparalleler Magnetisierung vorgesehen ist.

6. Indikator nach einem der vorhergehenden Ansprüche, dadurch gekennzeichnet, daß elektrische Mittel zur Anzeige der Umkehr der Magnetisierungsrichtung der Sensormagnete (1, 2) vorgesehen sind.

7. Indikator nach Anspruch 6, dadurch gekennzeichnet, daß der oder die Sensormagneten (1, 2) in einer Hall-Sonde (5) angeordnet sind.

8. Indikator nach Anspruch 6, dadurch gekennzeichnet, daß die Sensormagneten (1, 2) in Form von Impulsdrähten mit Pickup-Spulen (7, 8) vorliegen.

9. Indikator nach einem der Ansprüche 1 bis 6, dadurch gekennzeichnet, daß optische Mittel zur Anzeige der Umkehr der Magnetisierungsrichtung vorgesehen sind.

10. Indikator nach Anspruch 9, dadurch gekennzeichnet, daß mindestens ein Sensormagnet (1, 2) verschiebbar angeordnet ist.

11. Indikator nach Anspruch 10, dadurch gekennzeichnet, daß zwei Sensormagnete (1, 2) innerhalb einer Kammer (19) mit ursprünglich antiparalleler Magnetisierung angeordnet sind.

12. Indikator nach einem der vorhergehenden Ansprüche, dadurch gekennzeichnet, daß dem bzw. den Sensormagneten (1, 2) ein Richtmagnet (4) zugeordnet ist und daß das aus Sensor- und Richtmagnet bestehende System frei drehbar aufgehängt ist.

13. Indikator nach Anspruch 11 und 12, dadurch gekennzeichnet, daß der Richtmagnet (4) parallel zu den in der Kammer (19) befindlichen Sensormagneten angeordnet ist.

14. Indikator nach Anspruch 12, dadurch gekennzeichnet, daß Richtmagnet (4) und Sensormagnet (1) mit ihren Längsachsen hintereinander angeordnet sind und daß der Sensormagnet (1) längsverschieblich ist.

15. Indikator nach Anspruch 14, dadurch gekennzeichnet, daß dem Richtmagnet und dem Sensormagnet elektrische Kontakte (13, 14) zugeordnet sind.

16. Indikator nach Anspruch 14 oder 15, dadurch gekennzeichnet, daß zur Bildung des Raumes (12), in dem der Sensormagnet (1) längsverschieblich ist, ein Glasröhrchen vorgesehen ist.

17. Indikator nach einem der Ansprüche 12 bis 16, dadurch gekennzeichnet, daß das aus Richtmagnet und Sensormagnet bestehende System cardanisch aufgehängt ist.

18. Indikator nach einem der Ansprüche 12 bis 17, dadurch gekennzeichnet, daß aus Richtmagnet und Sensormagnet bestehende System innerhalb einer durchsichtigen Kugel angeordnet ist.

19. Indikator nach Anspruch 18, dadurch gekennzeichnet, daß die Kugel sich frei drehbar innerhalb einer Flüssigkeit befindet.

FIG.1

FIG.2

FIG.3

FIG.4

FIG.5

FIG.6a

FIG.7a

FIG.6b

FIG.7b

FIG.8

FIG.9a

FIG.9b

FIG.10a

FIG.10b

FIG.11a

FIG.11b